# DEMANDE DE BREVET EUROPEEN

(11) **EP 1 180 692 A1**
(43) Date de publication de la demande: **20.02.2002**
(21) Numéro de dépôt: 01402186.9
(22) Date de dépôt: 16.08.2001
(51) Int. Cl.: G01R 31/36, H02J 7/00

(54) **Procédé de test d'une batterie au plomb en vue de sa charge dans des conditions optimales**

(30) Priorité: 17.08.2000 FR 0010690
(71) Demandeur: HAWKER SA, 62000 Arras (FR)
(72) Inventeur: Kechmire, Mohamed, 62117 Brebieres (FR)
(74) Mandataire: Neyret, Daniel

(57) **Abrégé**

Procédé de test d'une batterie au plomb en vue de sa charge dans des conditions optimales, caractérisé en ce qu'il consiste à tester la batterie au plomb en vue d'obtenir des informations se rapportant à l'état de celle-ci en lui appliquant une intensité et/ou une impulsion d'essai et en relevant la tension aux bornes de la batterie.

## Description

La présente invention est relative à la charge des accumulateurs au plomb et se rapporte plus particulièrement à la charge de tels accumulateurs à électrolyte libre ou immobilisé.

Il est souhaitable de connaître l'état de charge d'une batterie avant même de commencer sa charge, afin d'une part d'estimer sa capacité résiduelle, ce qui renseigne sur le pourcentage de charge disponible et d'autre part, d'éviter de charger une batterie défectueuse pouvant entraîner sa destruction de façon irréversible.

Ainsi, la connaissance de l'état de la batterie s'avère indispensable pour optimiser sa recharge dans les meilleures conditions sans altérer sa durée de vie ou sa capacité nominale en fonction du nombre de cycles. Néanmoins, l'ensemble des chargeurs disponibles sur le marché ne dispose pas de suffisamment d'informations permettant de connaître l'état de la batterie à charger.

Plusieurs profils de recharge coexistent, mais ces derniers ne tiennent pas compte réellement de l'état de charge, ils sont principalement basés sur la réaction des éléments magnétiques vis à vis de la tension de la batterie présentée car ils utilisent soit des transformateurs à fuites (simple ou double pente), soit des chargeurs ferrorésonnants dont la tension de sortie est liée à l'évolution de la tension de la batterie.

L'ensemble des chargeurs classiques (chargeurs fonctionnant aux fréquences électrotechniques 50 Hz) dispose généralement d'une minuterie préréglée déclenchée soit au premier palier soit au deuxième palier dit Vgaz. Cependant, si une batterie est faiblement déchargée, la charge a lieu pendant l'intervalle de temps préréglé pouvant ainsi chauffer la batterie inutilement. Il est également un fait que le maintien du coefficient de surcharge en fonction du pourcentage de décharge n'est pas aisé.

Plusieurs techniques connues à ce jour dues aux progrès des véhicules électriques et à la connaissance des batteries exigent la connaissance de la tension de charge de chaque élément ou de chaque monobloc ainsi que sa température, et ce, pour connaître les dispersions possibles mais également pour compenser la tension en fonction de la température.

Pour connaître l'état de charge, il est nécessaire de disposer d'une électronique sophistiquée mesurant l'ensemble des paramètres les plus pertinents (tensions, courant, température) pour activer les algorithmes de calcul afin de connaître l'énergie disponible comme décrit dans le document FR-2 702 884 A1.

Cette approche, si elle est valable dans le cadre d'un véhicule électrique, ne trouve pas sa justification dans la manutention au regard des coûts pour l'installation et les matériels nécessaires.

Les procédés de charge des batteries à électrolyte libre sont difficilement transposables aux batteries à électrolyte immobilisé "gélifié", car le transfert d'énergie, s'il est identique en début de charge pour une batterie déchargée, se différencie de façon significative dès que la tension de la batterie atteint sa tension de dégazage "Vgaz" en moyenne de 2,37 V/élément à 30°C.

En effet, si la croissance de la tension en deçà de Vgaz peut être tolérée pour les batteries au plomb ouvertes, elle est fortement déconseillée pour les batteries étanches (batterie à électrolyte gélifié ou absorbé) car une augmentation du potentiel signifie un dégagement gazeux pouvant entraîner une détérioration de la batterie ou une perte de capacité.

Cependant, dès qu'on atteint un courant de fin de charge de faible valeur (variable entre C5/100 et C5/200 au lieu de C5/20 et C/30 pour les batteries à électrolyte libre) on autorise alors une montée en tension sans risque de dommage, avec cependant, une limitation de la tension à une valeur Vmax (variable entre 2,6 et 2,75 V/élément).

Plusieurs profils de charge existent, les plus couramment utilisés étant WA, WOWa, WU, WUIa, IU, IUIa, etc... Toutefois, il est conseillé de disposer de sécurités telles que, la limitation des temps de charge suivant les différents paliers, la limitation en tension, la limitation en capacité voire en température pour les chargeurs classiques ne disposant pas d'un système calculant la capacité réelle de la batterie en cours de charge.

Les profils les mieux adaptés pour la recharge des batteries à gel ou à électrolyte libre semblent être le profil WUIa ou IUIa avec comme variante le réglage (amplitude, durée) du courant de fin de charge selon la technologie employée, le temps de charge recherché, et le facteur de charge nécessaire. Le rôle du courant de fin de charge la est également l'homogénéisation de l'électrolyte le long de la plaque pour permettre l'équilibrage des tensions de fin de charge des éléments n'ayant pas pu recouvrer leurs tensions finales.

Exemple du profil IUIa : ce dernier se compose de trois paliers distincts :

Le premier palier de courant I est fonction de la capacité de la batterie.

Ce courant ne doit être ni trop important pour ne pas détériorer les éléments, ni trop faible pour ne pas pénaliser le temps de charge du premier palier et en conséquence la durée de charge totale.
- la première possibilité est de régler le chargeur en fonction de la batterie qui lui est connectée. Cependant, des batteries de capacités différentes ne peuvent être branchées sur le même chargeur ; en conséquence, le chargeur devient mono capacité.
- une deuxième possibilité consiste à déterminer la capacité de la batterie et à adapter le courant de charge à la capacité et à l'état de charge de la batterie.

Le deuxième palier en tension U est fonction du type de batterie en présence. Aussi, à partir de 2,37 V/élément à 30°C, la réaction chimique interne s'accentue par électrolyse de l'eau pour créer un dégagement gazeux. Cette tension est appelée tension de dégazage "VGAZ". Aussi, il est déconseillé de dépasser cette tension pour les batteries étanches sous peine de détruire la batterie par dégagement gazeux à l'extérieur des éléments.

Le troisième palier en courant la est fonction de la technologie de la batterie employée, son amplitude et sa durée dépendent de la capacité C5, de la profondeur de décharge et du facteur de charge recherché.

### Exemples :

1) pour une batterie à gel, le courant la aura une amplitude comprise entre C5/100 et C5/200, et une durée comprise entre 1 et 4 heures selon la profondeur de décharge, et le facteur de charge exigé (typiquement le facteur de charge est de l'ordre de 1,05 à 1,07).
2) pour une batterie à électrolyte libre, le courant la aura une amplitude de C5/20 et C/30, une durée comprise entre 1 heure et 3 heures selon la profondeur de décharge et le facteur de charge exigé (typiquement de l'ordre de 1,15).

L'invention a pour objectif d'optimiser la recharge de batteries des deux types de technologies (étanches et PbO) avec les mêmes principes de calcul de la capacité afin d'une part de connaître le courant de charge en fonction de la capacité de la batterie, mais également d'optimiser le coefficient de recharge pour éviter tout risque d'échauffement inutile, d'autre part de s'assurer une bonne recharge quelles que soient les conditions initiales avec un minimum d'incertitude en tenant compte des défauts liés à la batterie (surdécharge profonde, tension inadaptée, élément défectueux, etc).

Elle vise également à obtenir le meilleur compromis coefficient de surcharge/coefficient de décharge, de la température et de l'âge de la batterie afin de maintenir la capacité de la batterie pendant sa durée de vie.

Le procédé de charge a pour objectif une amélioration des procédés existants n'offrant pas une prise en compte de l'ensemble des paramètres permettant une optimisation de la recharge. Ceci garantit une pleine charge de la batterie sans altérer sa durée de vie. Le procédé employé pour la recharge des batteries au plomb à électrode liquéfié comporte en plus du profil pour batterie à gel, des impulsions de courant qui permettent d'obtenir une influence favorable sur la durée de vie des éléments, mais également il contribue à éviter les pertes de capacité prématurées comme décrit dans l'article " T-AM et al, page 215, Journal of Power Source 53, 1995".

L'invention a donc pour objet un procédé de test d'une batterie au plomb en vue de sa charge dans des conditions optimales, caractérisé en ce qu'il consiste à tester la batterie au plomb en vue d'obtenir des informations se rapportant à l'état de celle-ci en lui appliquant une intensité et/ou une impulsion d'essai et en relevant la tension aux bornes de la batterie.

Suivant d'autres caractéristiques de l'invention :
- il comprend une étape de réglage de l'intensité par génération d'une fonction à fréquence variable destinée à produire un cycle d'essai comprenant la production d'une intensité qui augmente jusqu'à une valeur de référence choisie selon la capacité de la batterie, puis se maintient un temps déterminé défini par la capacité de la batterie et diminue de telle sorte qu'il y a une excitation significative de la batterie jusqu'à obtenir une tension voisine de sa tension de dégazage ou supérieure à cette tension.

L'invention a également pour objet un dispositif de test d'une batterie au plomb, caractérisé en ce qu'il comprend un dispositif de réglage de l'intensité comprenant un générateur de fonction à fréquence variable destiné à produire un cycle d'essai comprenant la production d'une intensité qui augmente jusqu'à une valeur de référence choisie selon la capacité de la batterie, puis se maintient un temps déterminé défini par la capacité de la batterie et diminue de telle sorte qu'il y a une excitation significative de la batterie jusqu'à obtenir une tension voisine de sa tension de dégazage ou supérieure à cette tension.

Suivant d'autres caractéristiques :
- le dispositif est un générateur de courant puis de tension à grande dynamique de sortie ;
- le générateur de courant délivre un courant de pente variable suivant la capacité de la batterie.

Le procédé et le dispositif associé peuvent être utilisés pour obtenir des informations concernant la batterie par exemple le nombre d'éléments, la capacité restante de la batterie, le niveau de décharge. Le dispositif et le procédé peuvent également détecter des défauts avant le début de la charge (batterie inadaptée en tension, élément détérioré). Ainsi, par ce diagnostic, on chargera la batterie au mieux en fonction de son état tout en mémorisant les défaillances lors du cycle de charge.

Suivant une forme d'exécution du processus de calcul par des impulsions d'intensité, d'amplitude variable mais de durée fixe, cette amplitude variable dépend de la réaction de la tension de la batterie. Le calcul détermine le courant de début de charge après diagnostic, avant la mise en charge pour éviter une recharge sur batterie inadaptée.

Durant cette phase commune aux deux types de technologie, on détermine après quatre à cinq séries d'impulsions d'intensité l'état de charge de la batterie. Ce chiffre peut être variable en fonction du type de la batterie : par exemple pour une batterie à électrolyte gélifié, ce chiffre est par exemple de 4, mais pour des batteries à électrolyte libre, ce chiffre peut aller par exemple au-delà de 5 pour les fortes capacités.

Le premier groupe d'impulsions a pour effet de stimuler la batterie, et d'éviter certains phénomènes aléatoires liés au processus électrochimique lors de réactions. Les mesures d'estimation de la capacité se feront uniquement après un certain temps (temps nécessaire pour éviter les constantes de temps des réactions chimiques de l'électrode positive, et de l'électrode négative avec l'électrolyte). Ce retard de la mesure après un temps Tr permet d'éviter également les phénomènes transitoires pouvant se produire en début de charge et engendrer des erreurs de mesures.

L'invention sera mieux comprise à la lecture de la description qui va suivre, donnée uniquement à titre d'exemple et faite en se référant aux dessins annexés, sur lesquels :
- la Fig.1 est un schéma électrique d'un dispositif de charge muni du dispositif de test suivant l'invention ;
- la Fig.2 est un graphique représentant la forme d'onde d'intensité de charge fournie pendant le cycle d'essai et la tension de batterie en réaction à cette intensité ;
- la Fig.3 est un graphique en fonction du temps de la tension de régulation par paliers pour une batterie au gel ;
- la Fig.4 est un graphique en fonction du temps du courant de charge de la batterie avec la tension de régulation de la figure 3 ;
- la Fig.5 est un graphique représentant la courbe de puissance maximum ;
- la Fig.6 est un graphique représentant la variation de la largeur de boucle ;
- la Fig.7 représente l'évolution de la densité en fonction du pourcentage de charge ;
- la Fig.8 représente un exemple type de profil comprenant le procédé suivant l'invention ; et
- la Fig.9 montre une courbe d'évolution du pourcentage de charge en fonction de la tension à vide et le lien entre cette caractéristique et celle de la largeur de boucle.

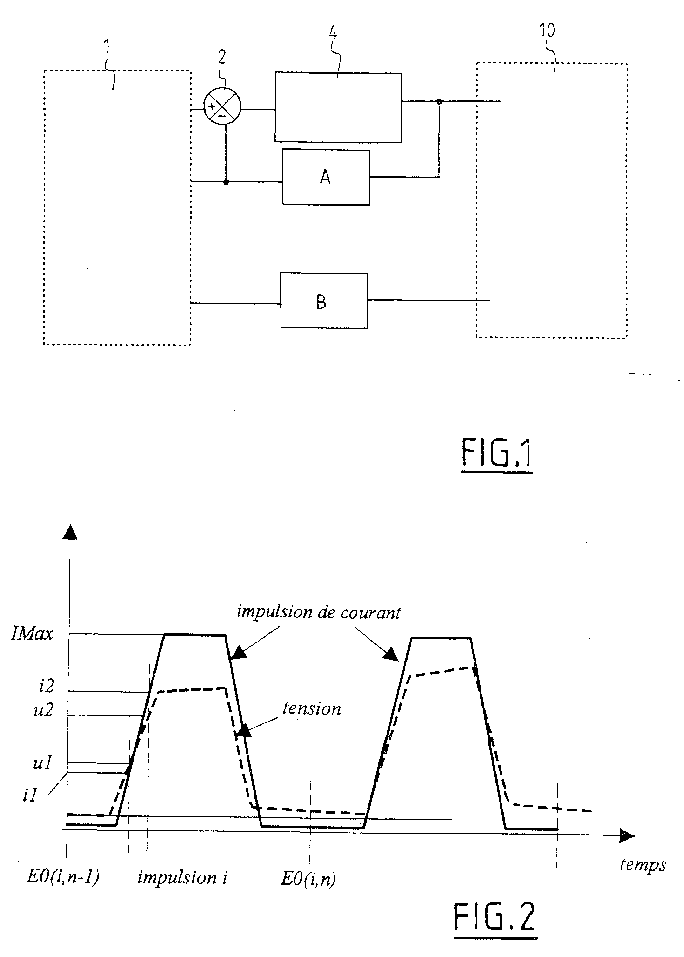

Le chargeur représenté à la figure 1 comporte un microprocesseur 1 à une première sortie duquel est connecté un sommateur 2 dont la sortie est connectée à un convertisseur 4.

Une seconde sortie du microprocesseur 1 est reliée à un circuit A de détermination d'un courant de référence dont l'entrée est connectée à la borne négative du sommateur 2 et dont la sortie est reliée à la sortie du convertisseur.

Une troisième sortie du microprocesseur 1 est reliée à un circuit B générateur de tension.

La sortie du circuit B est connectée à une borne de tension d'une batterie 10.

La sortie du convertisseur 4 est connectée à une borne de débit de courant de la batterie 10.

La figure 2 illustre la forme d'onde de l'intensité de charge qui est fournie pendant le cycle d'essai et la tension de la batterie en réaction à cette intensité. Le niveau d'intensité IMAX est réglé en fonction de la capacité de charge réelle de la batterie ; par exemple le niveau d'intensité de l'impulsion est égal à la capacité de la batterie divisée par N (N chiffre compris entre 4 et 7 suivant l'état de charge de la batterie). La pente des rampes positive et négative devra être comprise par exemple entre 20 et 40 A/S suivant la capacité de la batterie. Une pente de valeur différente peut être envisagée.

La durée du palier à courant constant est fixée à deux secondes, mais peut être différente.

Le premier groupe d'impulsions du courant est dit "groupe de conditionnement " ; il effectue un brassage de l'électrolyte et prépare la batterie à recevoir le deuxième groupe d'impulsions servant à faire les relevés de la caractéristique de tension aux bornes de la batterie.

Durant les impulsions, on calcule le pourcentage de charge qui sera mémorisé après 4 à 5 cycles de test comme pourcentage initial de la batterie, mais durant ces cycles on ne prélèvera pas la caractéristique tension-intensité car le risque d'erreur est important en cas de batterie fortement déchargée. Afin d'éviter ce risque, on analysera le comportement de la tension de batterie à courant nul.

La tension de batterie est constamment surveillée pendant le cycle d'essais pour qu'elle ne dépasse pas la tension VMAX, ce qui endommagerait la batterie.

L'amplitude d'impulsion est donc écrêtée en cas de dépassement pour ramener la tension de batterie dans les limites acceptables pour la batterie.

Après l'envoi d'une impulsion de courant, de durée, et d'amplitude variable à la batterie, celle-ci agit comme un circuit électrique de type Vbatt = Eₒ + RI, avec R : résistance de polarisation, I : courant d'excitation, et Eₒ tension à vide de la batterie.

Ainsi, par cette impulsion, on crée une croissance de type RI qui se superpose à une charge de type condensateur en supposant que la résistance de polarisation reste constante sur une période de mesure.

La période de mesure est caractérisée comme décrit dans la figure 2.

### Phase d'excitation

1) une croissance linéaire de type I=a t à pente variable entre 20 A/s et 40A/s, cette pente pouvant être plus importante selon la capacité de la batterie.
2) un palier à courant constant de durée variable selon la capacité et l'état de charge de la batterie.
3) une décroissance linéaire de type I = - a t de même pente que le cas 1.

### Phase de relaxation I = 0

Cette phase a une durée fixe quelque soit la capacité ou profondeur de décharge de la batterie ; elle permet la mesure de la tension Vbatt à I = 0 afin de connaître l'évolution de Eₒ.

La mesure s'effectue de la façon suivante :
- mesure de la tension à vide dans la phase d'excitation E_{o(i,n-i)}
- lors de la phase d'excitation, on mesure différentes valeurs uᵢ(iᵢ)
- mesure de la tension à vide après une phase d'excitation E_{o(i,n)} i,n ∈N* + avec i rang de l'impulsion et n le nombre de mesures

Ces mesures serviront à différents calculs qui seront expliqués postérieurement.

Chaque impulsion de mesure permet de donner une bonne approximation de la capacité nominale de la batterie grâce à la caractéristique tension-intensité. Lors de cette impulsion, le système mémorise les tensions u₁(i₁) et u₂(i₂) obtenues à des courants respectifs i₁ et i₂. Comme on le voit à la figure 2, ces mesures sont effectuées dans la rampe positive de l'impulsion de mesure. Les évaluations de la tension ne se font pas directement aux bornes de la batterie. Il est nécessaire d'effectuer une correction pour compenser la chute de tension dans les câbles de puissance.

Le calcul de la capacité nominale est basé sur la variation de tension du = u₂(i₂) - u₁(i₁) en réponse à une variation de courant di = i₂ - i₁ voir figure 2. Le terme (du) est corrigé pour s'affranchir de la tension présente aux bornes des câbles de puissance lors de l'évaluation. Pour cela, le système doit être paramétré en fonction des paramètres suivants.

b : coefficient expérimental de pondération (tenant compte de certains paramètres liés aux batteries au plomb).

Δu : chute de tension dans le câble :

Δu = R*I avec R résistance du câble et I courant de charge

N représente le nombre d'éléments constituant la batterie.

L'équation sera du type C =b* di/[(N*du)- Δu)]

Cette capacité calculée permettra de connaître le courant de début du premier palier, courant qui servira par la suite au paramètrage du processus de charge.

Ainsi, après la phase d'estimation de la capacité C5, le courant de charge est fonction de l'acceptance de la batterie. Ce dernier est de l'ordre de la capacité C₅/N (N est un chiffre compris entre 4 et 7 suivant l'état de la charge de la batterie et C₅ est la capacité que peut fournir la batterie en 5h, c'est à dire 100% de la capacité de la batterie).

Pour débuter la charge, la tension de batterie est relevée lorsque le chargeur débite son courant nominal. Cette tension devient la valeur de référence pour la régulation en tension Vreg. Vreg évolue avec une période fixe mais avec une amplitude variable. L'amplitude de la tension Vreg est fonction de l'évolution de l'état de charge de la batterie. Plus la batterie est chargée, plus la valeur de la tension de réglage de Vreg diminue.

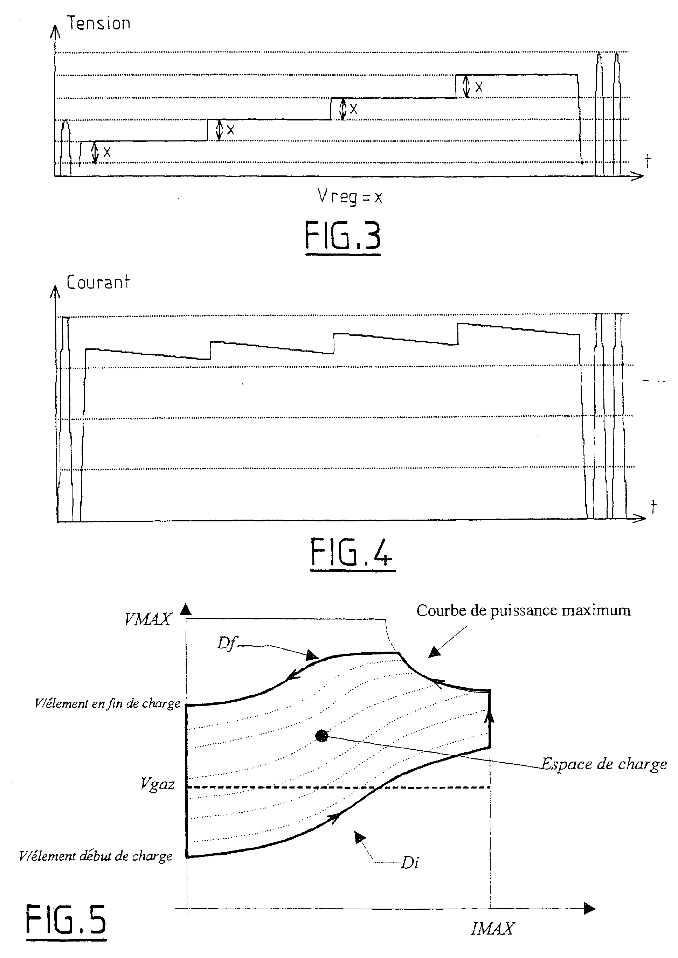

Ainsi, durant la période de régulation si le courant de charge est supérieur au courant de régulation, il y aura alors augmentation de la tension de la batterie par rapport à la tension Vreg, ce qui, au travers de la boucle de régulation imposera l'ajustement du courant de charge de telle sorte que la tension de la batterie soit constante sur la période de régulation et égale à Vreg comme représenté aux figures 3 et 4.

La figure 3 quant à elle montre un exemple d'application sur batterie au gel où la tension de régulation est fixée par paliers de valeur différente, mais de durée fixe selon l'évolution de la tension totale de la batterie.

La croissance de la tension par paliers permet de mieux contrôler l'état de charge de la batterie, et pouvoir jauger l'état d'acceptance de celle-ci, car si pour un pas de régulation de tension donné, la tension de la batterie diverge de celle de Vreg, ceci explique que le courant de charge ne soit pas adapté à l'acceptance de charge de la batterie, et par voie de conséquence, il y aura diminution du courant jusqu'à obtenir une tension de la batterie en concordance avec l'évolution de Vreg.

Le profil de charge devient dès lors entièrement dépendant de l'évolution de la tension de régulation, et par voie de conséquence, auto-adaptable selon le comportement de la tension de batterie soumise à un courant de charge. Le principe de charge que l'on vient de décrire peut être valable aussi bien pour la charge des batteries étanches que celles à électrolyte ouvert et de ce fait se distingue du profil classique type IUIa.

Ainsi, en fournissant par exemple dans le cadre d'une batterie à gel un palier de référence en tension Vreg, ce dernier permet de maintenir le courant de régulation durant la phase de la charge à une valeur proche du courant maximum toléré par la batterie, selon sa capacité de charge jusqu'à une tension par élément comprise par exemple entre 2,3 et 2,42 V suivant la température de l'électrolyte de la batterie.

Après cette phase commune d'estimation de la capacité, et de réglage de la tension Vreg, il existe deux variantes distinctes pour la recharge des batteries au plomb.

### Variante 1 : Charge d'une batterie à électrolyte libre.

- la tension de la batterie est mesurée avant l'impulsion de mesure (E_{o(i,n-1)}) et après celle-ci (E_{o(i,n)}) à un courant de composante égale à zéro. Ces deux tensions correspondent à l'écart de potentiel de la caractéristique tension-intensité de la batterie.

La différence entre ces deux tensions donne l'écart Wᵢ(largeur de boucle) = E_{o(i,n)} - E_{o(i,n-1)}). Cet écart se caractérise par une évolution de la tension de la batterie reflétant l'évolution de l'état de charge. La largeur de boucle E_{o(i,n)} - E_{o(i,n-1)} est représentative du niveau de charge de la batterie.

La figure 5 correspond au début de transfert d'énergie là où l'acceptance de la batterie semble être identique pour les deux technologies au Plomb (étanche, PbO) et où le rendement du transfert énergétique est maximum dans le domaine Di Domaine initial; la largeur de boucle est quasiment nulle (forte résistance de polarisation). Cette figure montre également la caractéristique de la batterie complètement chargée dans le domaine proche de Df Domaine final, domaine dans lequel l'évolution de la tension de la batterie est quasi constante dans une plage de courant donnée, puis décroît rapidement. L'évolution de la caractéristique v(i) pour une batterie chargée lors des impulsions de mesures et de brassage électrique se situe près de la zone de saturation, zone pouvant avoir un effet néfaste sur la batterie si celle-ci est maintenue dans cet espace de charge, car il y aurait des pertes d'eau par électrolyse et élévation de la température. Aussi, cette zone peut être explorée sans risque par les impulsions de mesure ayant une durée très courte par rapport au processus normal de charge.

Pour éviter des phénomènes de saturation dans le plan V, I, on imposera une puissance maximum de sortie à ne pas dépasser lors de cycle normal de charge, de telle sorte que quel que soit le cycle d'essais ou d'analyse, le point de fonctionnement restera à l'intérieur d'une zone autorisée.

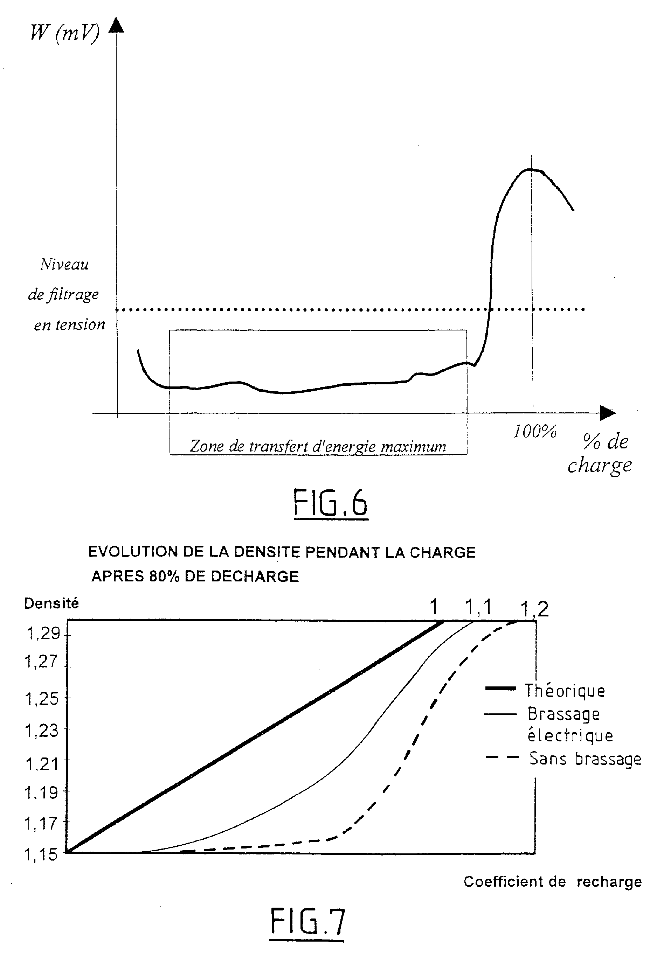

La figure 6 représente la variation de la largeur de boucle durant la charge. Elle est quasiment nulle pendant la plus grande partie de la charge. Elle monte brusquement à l'approche des 100% de charge pour atteindre une valeur maximale, puis, redescend légèrement. Cette augmentation rapide s'explique d'une part par l'agitation thermique due à l'électrolyse de l'eau pour les batteries à PbO et d'autre part par une augmentation de la résistance de passage des électrons dans les différentes couches (Pb, PbO2 et H2SO4) et baisse de la résistance de polarisation.

Le système pilotant le chargeur calcule la pente à chaque impulsion de mesure et détermine si le maximum est atteint, auquel cas on a atteint les 100% de charge.

La méthode de calcul du pourcentage de charge permet d'estimer le courant à injecter à chaque période de réglage de la tension de régulation durant le premier palier de charge. La période de régulation peut être variable selon la capacité de la batterie à charger et son pourcentage de charge. Elle sera par exemple dans la présente application de l'ordre 6 minutes.

Il convient de rappeler que la charge de la batterie est constituée d'une succession de phases de transfert d'énergie et d'impulsions de mesure de durée nettement plus courte. De même, les caractéristiques de la batterie sont déterminées pendant ces impulsions de mesure.

Le procédé de rapprochement des impulsions de mesure est basé sur le calcul du pourcentage de charge. Plus ce dernier croît, plus il faut réajuster son calcul selon deux principes :
- augmentation de la fréquence des impulsions de mesure et de brassage; dans la présente application cette fréquence est multipliée par deux ;
- rééquilibrage des équations de calcul selon l'évolution de la tension à vide.

Cependant, les impulsions de mesure ne doivent pas être trop rapprochées au risque d'avoir des variations trop faibles, d'une impulsion de mesure sur la suivante, et de considérer ainsi que la batterie est totalement chargée.

La fréquence des impulsions de courant agit directement sur l'estimation du pourcentage de charge mais également sur l'évolution de la caractéristique de la densité de l'électrolyte.

En effet, ces impulsions par leurs niveaux de courant élevé créent un brassage électrique de l'électrolyte, brassage qui permet d'obtenir une bonne homogénéité de la densité de l'acide sulfurique H₂SO₄ le long des plaques pour éviter les phénomènes de stratification mais également une réduction significative de la consommation d'eau et la réduction du facteur de charge. Ce brassage électrique à fréquence variable est fonction de l'état de charge de la batterie. Son évolution est liée au calcul du pourcentage de charge. Plus ce dernier est proche de 100% de l'état de charge, plus la fréquence augmente afin de mieux brasser l'électrolyte et permettre une réduction de la consommation d'eau et une optimisation du facteur de charge (le facteur de charge typique pour une batterie à électrolyte libre déchargée à 80% est de l'ordre de 1,15 pour obtenir une densité de 1300 à 30°C permettant d'avoir une batterie pleinement chargée; en corollaire avec le brassage électrique, le facteur de charge est réduit à 1,08-1,10 donnant une densité de 1300 à 30°C et une batterie totalement chargée). Un exemple est ainsi fourni par la figure 7 montrant l'évolution de la densité en fonction du pourcentage de charge.

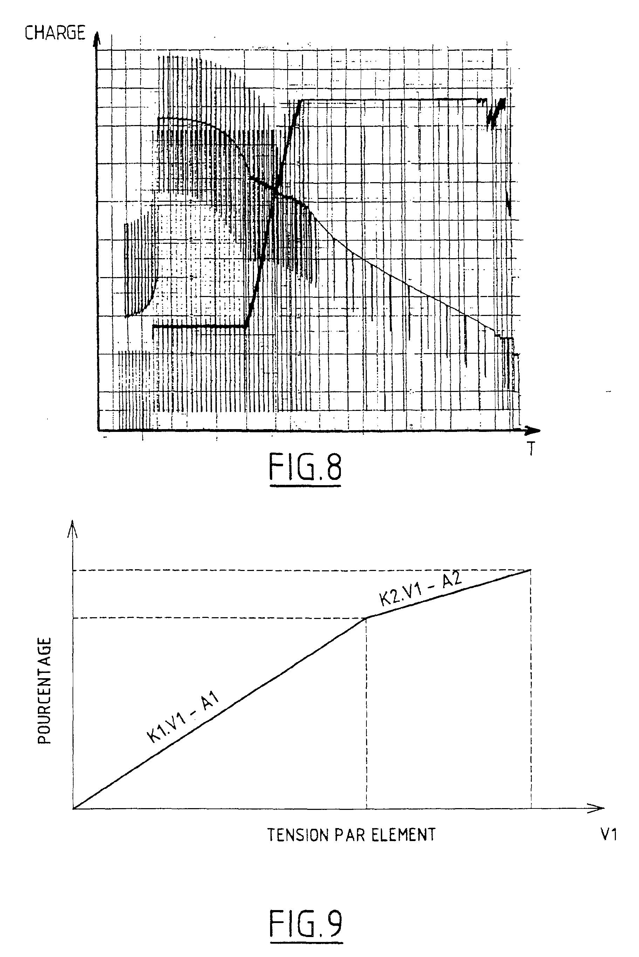

De plus, le brassage électrique (ionique) a un effet bénéfique sur le vieillissement de la batterie comme décrit dans l'article -.T-AM et al. Page 215, Journal of Power Source 53, 1995. Un exemple type d'un profil comprenant ce procédé est représenté à la figure 8.

Ce sont ces impulsions de mesure qui sont à la base de cette méthode. En effet, au début de chaque impulsion de mesure, c'est à dire lorsque le courant délivré est de composante égale à zéro, la tension de la batterie est relevée. D'après cette tension, appelée tension de relaxation de la batterie, on établit la correspondance avec une table préétablie suite à plusieurs essais à des niveaux de charge différents. Cela donne l'information concernant le niveau de charge effectif de la batterie.

A mesure que le transfert d'énergie continue, le niveau de charge peut être connu par une impulsion de mesure.

La figure 9 montre la courbe de l'évolution de pourcentage de charge en fonction de la tension à vide, et le lien entre cette caractéristique et celle de la largeur de boucle. Ainsi, grâce à ces deux caractéristiques, on maîtrise mieux l'évolution de la charge par le contrôle de son courant de charge.

Les pourcentages de charge initial et final (100%) permettent également de fixer le courant de fin de charge selon la capacité de la batterie et par voie de conséquence d'optimiser le facteur de charge selon les critères des fabricants de batteries.

Une fois la batterie chargée totalement, la phase de charge de maintien est activée suivant le courant calculé de fin de charge sous forme d'impulsion. Un exemplaire de profil de charge est joint en annexe figure 8 précisant l'allure de la courbe, ainsi que la présence des impulsions de calcul et de brassage électrique (ionique).

### Variante 2 : Charge et batterie à gel

Le profil IUIa pour batterie à électrolyte gélifié se différencie principalement dans ses phases 2 et 3 par rapport à celui pour la batterie à électrolyte libre.

En effet, comme cela a été mentionné dans le préambule, il faut considérer certaines précautions pour la recharge de batteries à gel telles que le strict respect de la tension de régulation (ici elle est de 2,37 V/élément à 30°C), mais également le respect du courant de fin de charge, ainsi que de sa durée.

Le procédé de charge ainsi défini permet la charge de batterie étanche (gel) dans les meilleures conditions pour la batterie. Ce procédé permet de recharger différentes gammes de capacité (capacité limitée uniquement par la puissance de sortie du chargeur) sans aucune adaptation, car le procédé adaptera automatiquement son processus de charge à la capacité de la batterie et à sa profondeur de décharge, évitant ainsi tout échauffement anormal ou risque de dommage de la batterie.

Les moyens exposés ci-dessus permettent d'obtenir ainsi par le biais d'un chargeur à grande dynamique, la possibilité de charger différents types de technologies, de tensions et de capacités de batteries et de ce fait d'avoir un chargeur dont les fonctionnalités sont la multitension (par exemple un chargeur peut charger une batterie de 24V ou 36V ou 48V sans aucune intervention de l'opérateur), et la multicapacité (le même chargeur peut charger une batterie de 250 Ah ou une batterie de 600 Ah sans aucune intervention de l'opérateur).

## Revendications

1. Procédé de test d'une batterie au plomb en vue de sa charge dans des conditions optimales, **caractérisé en ce qu'**il consiste à tester la batterie au plomb en vue d'obtenir des informations se rapportant à l'état de celle-ci en lui appliquant une intensité et/ou une impulsion d'essai et en relevant la tension aux bornes de la batterie.

2. Procédé suivant la revendication 1, **caractérisé en ce qu'**il comprend une étape de réglage de l'intensité par génération d'une fonction à fréquence variable destinée à produire un cycle d'essai comprenant la production d'une intensité qui augmente jusqu'à une valeur de référence choisie selon la capacité de la batterie, puis se maintient un temps déterminé défini par la capacité de la batterie et diminue de telle sorte qu'il y a une excitation significative de la batterie jusqu'à obtenir une tension voisine de sa tension de dégazage ou supérieure à cette tension.

3. Procédé suivant la revendication 2, **caractérisé en ce qu'**il comporte une étape de calcul du pourcentage de charge permettant d'estimer le courant à injecter à chaque période de réglage de la tension de régulation durant un premier palier de charge.

4. Procédé suivant la revendication 3, **caractérisé en ce que** le processus de régulation est variable selon la capacité de la batterie à charger et son pourcentage de charge.

5. Procédé suivant l'une des revendications 2 à 4, **caractérisé en ce qu'**au début de chaque impulsion de mesure, lorsque le courant délivré à la batterie est de composante égale à zéro, on relève la tension de la batterie, d'après cette tension dénommée tension de relaxation de la batterie, on établit la correspondance avec une table préétablie suite à plusieurs essais à des niveaux de charge différents et on obtient ainsi une information concernant le niveau de charge effectif de la batterie.

6. Dispositif de test d'une batterie au plomb, **caractérisé en ce qu'**il comprend un dispositif de réglage de l'intensité comprenant un générateur (1,2,4) à fréquence variable destiné à produire un cycle d'essai comprenant la production d'une intensité qui augmente jusqu'à une valeur de référence choisie selon la capacité de la batterie (10), puis se maintient un temps déterminé défini par la capacité de la batterie et diminue de telle sorte qu'il y a une excitation significative de la batterie jusqu'à obtenir une tension voisine de sa tension de dégazage ou supérieure à cette tension.

7. Dispositif suivant la revendication 6, **caractérisé en ce qu'**il comprend un générateur de courant (A) puis de tension (B) à grande dynamique de sortie.

8. Dispositif suivant la revendication 7, **caractérisé en ce que** le générateur de courant (4, A) délivre un courant de pente variable suivant la capacité de la batterie.

9. Dispositif suivant l'une des revendications 6 à 8, **caractérisé en ce qu'**il comporte un système (1) pilotant le chargeur qui calcule la pente du courant à chaque impulsion de mesure et détermine si le maximum est atteint, traduisant une charge de 100%.
